# EUROPÄISCHE PATENTSCHRIFT

(11) **EP 1 570 316 B1**
(45) Veröffentlichungstag und Bekanntmachung des Hinweises auf die Patenterteilung: **26.07.2006**
(21) Anmeldenummer: 03780075.2
(22) Anmeldetag: 27.11.2003
(51) Int. Cl.: G03F 7/20, G03F 7/30, B41C 1/10

(54) **VORRICHTUNG UND VERFAHREN ZUR HERSTELLUNG VON FLEXODRUCKPLATTEN FÜR DEN ZEITUNGSDRUCK MITTELS DIGITALER BEBILDERUNG**
DEVICE AND METHOD FOR PRODUCING FLEXOGRAPHIC PLATES USING DIGITAL IMAGING, FOR NEWSPAPER PRINTING
DISPOSITIF ET PROCEDE DE FABRICATION DE PLAQUES FLEXOGRAPHIQUES PAR ILLUSTRATION NUMERIQUE POUR L'IMPRESSION DE JOURNAUX

(30) Priorität: 03.12.2002 DE 10256614
(43) Veröffentlichungstag der Anmeldung: 07.09.2005
(73) Patentinhaber: XSYS Print Solutions Deutschland GmbH, 70469 Stuttgart (DE)
(72) Erfinder: KESSENICH, Elmar, 67071 Ludwigshafen (DE); STEBANI, Uwe, 67592 Flörsheim-Dalsheim (DE); TELSER, Thomas, 69120 Heidelberg (DE); SANDIG, Hartmut, 67227 Frankenthal (DE)
(74) Vertreter: Isenbruck, Günter
(86) Internationale Anmeldenummer: PCT/EP2003/013366
(87) Internationale Veröffentlichungsnummer: WO 2004/051377

(56) Entgegenhaltungen:
- EP-A- 0 762 723
- EP-A- 1 091 253
- US-A- 3 981 583
- US-A- 6 016 188
- US-A- 6 085 657
- US-A1- 2001 022 145
- US-B1- 6 354 208

## Beschreibung

Die vorliegende Erfindung betrifft eine Vorrichtung zur in-line-Produktion von Flexodruckplatten mittels digitaler Bebilderung sowie ein Verfahren zum Herstellen von Zeitungsflexoplatten unter Verwendung der Vorrichtung.

Tageszeitungen werden heutzutage noch meistens nach dem Offset-Druckverfahren hergestellt. Zunehmend wird jedoch auch die Flexodrucktechnik zum Drucken von Tageszeitungen eingesetzt, weil Flexodruck eine Reihe von technischen Vorteilen aufweist. Beim Flexodruckverfahren kann der Druck systembedingt viel schneller angefahren werden als beim Offset-Verfahren, da im Unterschied zu Letzterem keine Einstellung des Farb-Wasser-Gleichgewichtes erforderlich ist. Neben der Zeitersparnis bedeutet dies auch eine erhebliche Papiererspamis. Weiterhin wird beim Offsetdruck nachteiligerweise mit pastösen, mineralölhaltigen Farben gedruckt. Beim Coldset-Offsetdruck verbleiben die Öle zum großen Teil im oder auf dem Papier, was signifikante Mengen an schwarzem Abrieb zur Folge hat, insbesondere auf den Fingern der Zeitungsleser. Bei Heatset-Offsetdruck werden die Mineralöle beim Trocknen der Druckfarbe freigesetzt. Beim Flexodruck mit Druckfarben auf Wasserbasis, die schnell ins Papier wegschlagen, ist der schwarze Abrieb deutlich reduziert und es werden keine Lösemittel emittiert. Die Druckmaschinen können auf einfache Art und Weise mit Wasser gereinigt werden.

Nachteilig am Flexodruck im Vergleich zum Offsetdruck ist jedoch, dass die Verarbeitungszeit vom fotoempfindlichen Flexodruckelement bis zur druckfertigen Flexodruckplatte erheblich größer ist als die entsprechende Verarbeitungszeit bei Offsetdruckplatten. Typische Verarbeitungszeiten für handelsübliche Flexodruckplatten liegen in der Größenordnung von 6 h und mehr. Für den Druck von Tageszeitungen mit Flexodruckplatten sind jedoch Verarbeitungszeiten von mehr als 30 min kaum noch akzeptabel. Es besteht daher ein Bedarf nach geeigneten Verfahren sowie verbesserten Apparaturen zur Verkürzung der Verarbeitungszeit.

Digitale Bebilderung von fotoempfindlichen Flexodruckelementen ist prinzipiell bekannt. Hierbei werden Flexodruckelemente nicht auf klassische Art und Weise durch Auflegen einer fotografischen Maske, gefolgt vom Belichten durch die fotografische Maske hindurch erzeugt. Die Maske wird vielmehr mittels geeigneter Techniken in-situ direkt auf dem Flexodruckelement erzeugt. Flexodruckelemente können beispielsweise mit opaken, IR-ablativen Schichten (EP-B 654150, EP-A 1 069 475) versehen werden, die mittels IR-Lasern bildmäßig ablatierbar sind. Weitere bekannte Techniken umfassen mittels Ink-Jet-Technik beschreibbare Schichten (EP-A 1 072 953) oder thermografisch beschreibbare Schichten (EP-A 1 070 989). Nach dem bildmäßigen Beschreiben dieser Schichten mittels der dazu geeigneten Techniken wird die fotopolymerisierbare Schicht durch die gebildete Maske hindurch mittels aktinischem Licht belichtet.

Zur digitalen Bebilderung IR-ablativer Schichten mittels IR-Lasern, werden üblicherweise Laserapparaturen mit rotierenden Trommeln eingesetzt, wie beispielsweise von EP-B 741 335 offenbart. Das Flexodruckelement wird auf die Trommel gespannt, die Trommel in Rotation versetzt und anschließend die IR-ablative Schicht bildweise mittels des Lasers bei rotierender Trommel abgetragen.

In unserer Anmeldung WO 03/14831 haben wir vorgeschlagen, zur Herstellung von Zeitungsflexoplatten dünne fotopolymerisierbare Flexodruckelemente mit einer Schichtdicke von 0,3 bis 1 mm auf metallischem Träger einzusetzen. Die offenbarten Flexodruckelemente können konventionell, d.h. mit Hilfe einer fotografischen Maske, oder mittels digitaler Bebilderung verarbeitet werden. Die Verarbeitung erfolgt mittels konventioneller Apparaturen.

Mit den besagten Flexodruckelementen lässt sich eine deutliche Verkürzung der Verarbeitungszeit erreichen. Es ist aber wünschenswert, die Verarbeitungszeit des fotoempfindlichen Ausgangsmaterials zur fertigen Flexodruckplatte noch weiter zu verkürzen.

Zeitverluste treten insbesondere im Zuge der IR-Ablation auf. Der Metallträger ist in einem gewissen Maße plastisch. Zur Montage auf die rotierende Trommel der Laserapparatur zur IR-Ablation muss der Träger gebogen werden, und er behält die gebogene Form auch nach dem Abnehmen von der Trommel zumindest teilweise bei. Da handelsübliche Auswaschvorrichtungen nur zur Verarbeitung flacher Platten eingerichtet sind, muss der Träger vor der weiteren Verarbeitung wieder gerade gebogen werden. Dies ist zum einen zeitaufwändig und zum anderen besteht auch die Gefahr, dass der Träger beim Geradebiegen geknickt wird. Ein Knick im Träger führt jedoch zu sichtbaren Störungen des Druckbildes. Es wäre daher äußerst wünschenwert, Flexodruckplatten im Zuge des gesamten Herstellungsprozesses flach verarbeiten zu können.

US 5,919,378 offenbart eine Vorrichtung zum vollautomatischen Auswaschen und Trocknen von Runddruckformen (Sleeves). Der Transport der Runddruckformen durch die Apparatur erfolgt mittels Spindeln, in die die Hülsen eingespannt werden. Die Runddruckformen werden außerhalb der Vorrichtung konventionell bildmäßig belichtet.

DE-A 42 31 103 und EP-A 225 678 offenbaren Vorrichtungen zum Transport von Flexodruckplatten durch eine Auswaschvorrichtung hindurch, mittels derer die Platte durch geeignete Stifte oder Leisten durch das Gerät gezogen wird.

DE-A 100 57 061 offenbart eine Druckvorrichtung zur Bebilderung von Offsetdruckplatten, die mehrere Druckköpfe aufweist.

Eine Vorrichtung zur Verarbeitung, digital bebilderbarer, fotopolymerisierbarer Flexodruckelemente zu fertigen Flexodruckplatten, insbesondere Zeitungsflexoplatten, welche zur Durchführung aller Schritte des Herstellverfahrens geeignet ist, und bei der die Platten in flachem oder ebenem Zustande prozessiert werden, ist bislang jedoch noch nicht bekannt.

Aufgabe der Erfindung war es, eine Vorrichtung zur Herstellung von Flexodruckplatten für den Zeitungsdruck mittels digitaler Bebilderung bereitzustellen, welche alle Verarbeitungsschritte umfasst, und in der die Flexodruckelemente bzw. -platten ohne Biegen, d.h. in ebenem Zustand, verarbeitet werden können, und die weiterhin eine schnellere Verarbeitung erlaubt. Aufgabe war es weiterhin, ein Verfahren zur Herstellung von Flexodruckplatten für der Zeitungsdruck unter Verwendung der besagten Apparatur bereitzustellen.

Dementsprechend wurde eine Vorrichtung zur in-line-Produktion von Flexodruckplatten mittels digitaler Bebilderung gefunden, welches mindestens
(A) eine Einheit zur Aufnahme digital bebilderbarer, fotopolymerisierbarer Flexodruckelemente,
(B) eine Einheit zur digitalen Bebilderung des Flexodruckelementes, die mindestens zwei gleichartige Funktionseinheiten ausgewählt aus der Gruppe von IR-Lasern, Ink-Jet-Druckköpfen oder Thermodruckköpfen , umfasst,
(C) eine Belichtungseinheit,
(D) eine Auswascheinheit,
(E) eine Trocknungseinheit,
(F) eine optionale Nachbehandlungseinheit,
(G) eine Ausgabeeinheit für die erhaltenen Flexodruckplatten, sowie
(H) Transporteinheiten für die Flexodruckelemente - bzw. formen, die die Einheiten (A) bis (G) miteinander verbinden umfasst,
wobei die Einheiten (A) bis (H) so ausgelegt sind, dass die Flexodruckelemente bzw. - platten in ebenem Zustande verarbeitet werden.

Weiterhin wurde die Verwendung der Vorrichtung zur Herstellung von Flexodruckplatten gefunden.

In einem weiteren Aspekt der Erfindung gemäß Anspruch 5 wurde ein Verfahren zur Herstellung von Flexodruckplatten für den Zeitungsdruck gefunden, bei dem man als Ausgangsmaterial ein fotoempfindliches Flexodruckelement umfassend -übereinander angebracht- mindestens
- einen flexiblen, metallischen Träger,
- eine fotopolymerisierbare Schicht, welche ihrerseits mindestens ein elastomeres Bindemittel, ethylenisch ungesättigte Monomere und einen Fotoinitiator umfasst, sowie
- eine digital bebilderbare Schicht, ausgewählt aus der Gruppe der IR-ablativen Schichten, Ink-jet-Schichten oder thermografrachen Schichten
einsetzt, bei dem man weiterhin eine Vorrichtung gemäß obiger Definition einsetzt und das Verfahren die folgenden Schritte umfasst:
(a) Einlegen der fotoempfindlichen Flexodruckelemente in die Aufnahmeeinheit (A),
(b) bildmäßiges Beschreiben der digital bebilderbaren Schicht mittels der Bebilderungseinheit (B) zur Erzeugung einer Maske auf dem Flexodruckelement,
(c) Belichten des Flexodruckelementes mit aktinischem Licht mittels der Belichtungseinheit (C) durch die erzeugte Maske hindurch ,
(d) Entfernen nicht belichteter Bereiche des Flexodruckelements sowie der Reste der digital bebilderbaren Schicht davon mittels eines geeigneten Lösemittels oder einer geeigneten Lösemittelkombination in der Auswascheinheit (D),
(e) Trocknen der ausgewaschenen Flexodruckform bei einer Temperatur von 105 bis 160°C in der Trocknungseinheit (E),
(f) Optional Nachbehandeln der getrockneten Flexodruckform mittel UVA- und/oder UVC-Licht,
(g) Ausgeben der fertigen Flexodruckplatte,
wobei das Flexodruckelement bzw. die -platte durch die Transporteinrichtung (H) von einer Einheit zu der jeweils nächsten befördert wird und während des gesamten Verarbeitungsvorganges nicht gebogen wird.

Zu der Erfindung ist im Einzelnen das Folgende auszuführen.

Die erfindungsgemäße Vorrichtung umfasst mindestens die Einheiten (A) bis (G), die auf eine geeignete Art und Weise mittels der Transporteinheiten (H) miteinander verbunden sind. Das Flexodruckelement bzw. die Flexodruckplatte wird in ebenem Zustande durch die Vorrichtung transportiert und verarbeitet.
Unter "Flexodruckelement" wird in prinzipiell bekannter Art und Weise das Ausgangsmaterial für das Verfahren oder ein Zwischenprodukt bezeichnet, während der Begriff "Flexodruckplatte" die fertige Flexodruckplatte bezeichnet.

Der Begriff "Einheit" ist im Sinne dieser Erfindung als "Funktionseinheit" zu verstehen. Bei der erfindungsgemäßen Apparatur kann es sich um einzelne Apparaturen handeln, die prinzipiell auch separat betrieben werden können, und die durch die Transporteinheiten zu einer größeren Apparatur miteinander verbunden werden. Bevorzugt handelt es sich aber um eine Apparatur, in die alle Funktionseinheiten integriert sind und bei der die einzelnen Einheiten nicht mehr unabhängig voneinander betrieben werden können. Besonders bevorzugt handelt es sich um eine abgeschlossene Apparatur, bei der nur an einer Stelle Flexodruckelemente eingelegt und fertige Flexodruckplatten an einer anderen Stelle entnommen werden.

Der Begriff "ebene Verarbeitung" oder "flache Verarbeitung" im Sinne dieser Erfindung bedeutet, dass das Verfahren keinerlei Schritte umfasst, bei der das Flexodruckelement oder die Flexodruckplatte bewusst in rundem bzw. gebogenem Zustande verarbeitet wird, d.h. beispielsweise um Zylinder oder dazu äquivalente Mittel gebogen wird, und die Apparatur dementsprechend konstruiert ist. Ebene Verarbeitung schließt selbstverständlich nicht aus, dass ein Flexodruckelement im Zuge des Verfahrens auch einmal an sich unbeabsichtigt um einen geringen Winkel gebogen werden könnte.

Einheit (A) dient zur Aufnahme digital bebilderbarer, fotopolymerisierbarer Flexodruckelemente als Ausgangsmaterial für das Verfahren. Im einfachsten Fall kann es sich dabei um eine einfache Aufgabevorrichtung handeln, in die die Flexodruckelemente einzeln manuell eingelegt werden, beispielsweise durch Auflegen auf ein Förderband oder Einlegen in eine Einzugsvorrichtung. Bevorzugt umfasst die Einheit (A) aber ein Magazin, welches einen größeren Vorrat an Flexodruckelementen enthält, aus dem die Flexodruckelemente bei Bedarf automatisch entnommen werden. Dies kann beispielsweise mittels eines Greifarmes oder einer Kippvorrichtung erfolgen. Bevorzugt handelt es sich bei dem Magazin um einen geschlossenen Behälter. Da fotoempfindliche Flexodruckelemente vor UV-Licht geschützt werden müssen, braucht bei einem geschlossenen Behälter der Raum in dem die erfindungsgemäße Vorrichtung aufgebaut ist, nicht als Ganzes vor UV-Licht geschützt zu sein.

Einheit (B) dient zur digitalen Bebilderung des Flexodruckelementes. Sie umfasst mindestens zwei gleichartige Funktionseinheiten zur digitalen Bebilderung ausgewählt aus der Gruppe von IR-Lasern, Ink-Jet- Druckköpfen oder Thermodruckköpfen. Bevorzugt umfasst Einheit (B) eine Vielzahl gleichartiger Funktionseinheiten zur digitalen Bebilderung. Es kann sich beispielsweise um 5 bis 50 Funktionseinheiten handeln. Durch das Zusammenwirken einer größeren Zahl von gleichartigen Funktionseinheiten wird eine schnellere Bebilderung des Flexodruckelementes erreicht. Durch die Einwirkung der Funktionseinheiten auf die digital bebilderbare Schicht des Flexodruckelementes wird eine Maske auf dem Flexodruckelement erzeugt.

Der Begriff "gleichartige Funktionseinheiten" bedeutet nicht notwendigerweise, dass die Funktionseinheiten identisch sein müssen. Er bedeutet lediglich, dass nach dem gleichen Prinzip arbeitende Funktionseinheiten zusammenwirken sollen, also beispielsweise nur IR-Laser oder nur Tintenstrahldruckköpfe. Diese können aber je nach der gewünschten Funktion entsprechend gestaltet werden. Es kann beispielsweise die eine Sorte von Funktionseinheiten speziell an das Schreiben gröberer Strukturen und die andere Sorte an das Schreiben feinerer Strukturen angepasst sein. Die einzelnen Funktionseinheiten sind jeweils individuell ansteuerbar.

Die Funktionseinheiten sind üblicherweise oberhalb des Flexodruckelementes angeordnet, so dass sie die digital bebilderbare Schicht möglichst senkrecht von oben bebildem können. Es sind aber auch Anordnungen denkbar, bei denen die Funktionseinheiten andersartig angeordnet sind.

Zur Bebilderung muss weiterhin eine Relativbewegung zwischen den Funktionseinheiten und dem zu bebilderndem Flexodruckelement erfolgen können. Hierzu können die Platte, die Funktionseinheiten oder beides bewegt werden. Die Bewegung der Funktionseinheit kann weiterhin durch die Bewegung der gesamten Einheit erfolgen. Es könnte sich aber beispielsweise auch um eine stationäre Laserquelle handeln, bei der nur der Laserstrahl, bspw. über ein System von Spiegeln gelenkt wird.

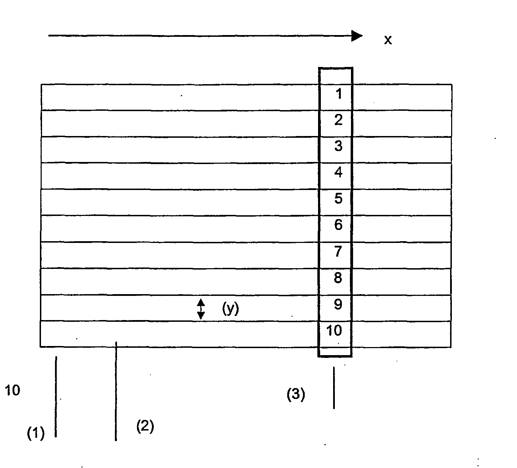

Ein Beispiel für eine zweckmäßige Anordnung der Funktionseinheiten ist in Abbildung 1 dargestellt. Hierbei sind 10 Funktionseinheiten entlang einer Leiste (3) angeordnet. Unter der Leiste (3) wird ein fotoempfindliches Flexodruckelement (1) mit digital bebilderbarer Schicht in x-Richtung hindurchgeführt. Alternativ kann auch das Flexodruckelement fixiert sein, während die Leiste bewegt in x-Richtung bewegt wird. Jede der zehn Funktionseinheiten bebildert jeweils einen Bereich (2) der digital bebilderbaren Schicht mit der Breite (y). Hierzu können die Funktionseinheiten beispielsweise in y-Richtung hin- und herbewegt werden und die Funktionseinheiten werden gemäß dem gewünschten Bild an- und abgeschaltet. Zweckmäßigerweise werden nicht die Funktionseinheiten einzeln bewegt, sondem die gesamte Leiste (3) wird in y-Richtung hin- und herbewegt. Selbstverständlich sind aber auch andere Bewegungsabläufe möglich. Einheit (B) umfasst weiterhin eine Regelungseinheit zur Synchronisierung der translatorischen Bewegung x mit der Bewegung der Funktionseinheiten. Es ist selbstverständlich auch möglich, eine so große Anzahl von Funktionseinheiten zu verwenden, dass auch bei feststehender Leiste eine vollflächige Bebilderung des Flexodruckelementes möglich ist.

Es sind auch andere Anordnungen der Funktionseinheiten möglich. Beispielsweise können zwei oder mehrere Leisten hintereinander angeordnet sein, oder die Funktionseinheiten können gegeneinander versetzt sein. Beispielsweise können die von DE-A 100 57 061 oder DE-A 37 30 844 offenbarten Anordnungen verwendet werden.

Die Art der Funktionseinheiten richtet sich nach der Art der digital bebilderbaren Schicht. Zur Bebilderung von Flexodruckelementen mit opaken, IR-ablativen Schichten werden IR-Laser eingesetzt. Bevorzugt handelt es sich hierbei um Diodenlaser, ohne dass die Erfindung darauf beschränkt sein soll. Hierbei wird die opake, IR-ablative Schicht an den Stellen, an denen sie von einem Laserstrahl getroffen wird, entfernt und die darunter liegende fotopolymerisierbare Schicht freigelegt. Um zu verhindern, dass die erfindungsgemäße Vorrichtung mit den Abbauprodukten der Schicht verunreinigt wird, sollte die Bebilderungseinheit bei dieser Ausführungsform zweckmäßigerweise eine Absaugvorrichtung aufweisen.

Die Bebilderung mittels Ink-Jet-Technik erfolgt nach dem umgekehrten Prinzip. Die digital bebilderbare Schicht ist transparent und diejenigen Stellen, die nicht vemetzen sollen, werden mit opaker Tinte abgedeckt. Bei den Funktionseinheiten handelt es sich dementsprechend um Ink-Jet-Druckköpfe.

Thermografische, digital bebilderbare Schichten sind transparent und werden unter dem Einfluss von Wärme opak. Geeignete Funktionseinheiten zum Beschreiben thermografischer Schichten sind beispielsweise IR-Laser oder Thermodruckköpfe.

Zweckmäßigerweise ist die Bebilderungseinheit (B) modular aufgebaut, so dass die Funktionseinheiten je nach der gewünschten Bebilderungstechnik leicht ausgetauscht werden können.

Die Belichtungseinheit (C) umfasst geeignete Strahlungsquellen zum Vemetzen der gewünschten Bereiche der fotopolymerisierbaren Schicht. Hierzu eignet sich insbesondere UVA-Strahlung oder UVA/VIS-Strahlung. Bei der Strahlungsquelle kann es sich beispielsweise um Röhren oder geeignet angeordnete punktförmige Lichtquellen handeln. Es wird üblicherweise in Gegenwart von Luftsauerstoff belichtet. Optional kann die Belichtungseinheit aber auch zur Belichtung unter einem Schutzgas wie Stickstoff oder Argon ausgerüstet sein.

Die Auswascheinheit (D) umfasst Mittel, um das belichtete Flexodruckelement mit einem geeigneten Auswaschmittel zu behandeln, beispielsweise durch Besprühen oder Eintauchen. Sie umfasst weiterhin üblicherweise bewegte Bürsten oder Vliese, um das Entfernen des nicht polymerisierten Polymers zu beschleunigen. Weiterhin umfasst die Auswascheinheit üblicherweise geeignete Mittel zur Zufuhr von frischem Auswaschmittel und zum Entfernen von verbrauchtem Auswaschmittel.

Die Trockeneinheit (E) dient zum Trocknen des feuchten Flexodruckelementes. Sie kann beispielsweise aus einer beheizbaren Kammer oder einem Trockenkanal bestehen. Die Wärmezufuhr kann beispielsweise über eingebaute Heizelemente erfolgen. Die Trockeneinheit kann aber auch vorteilhaft von einem warmen Trockengasstrom durchströmt werden. Selbstverständlich können die Beheizungsmöglichkeiten auch miteinander kombiniert werden. Als Trockner sollte ein Ablufttrockner verwendet werden, um die Lösemittelanreicherung im Gasraum zu unterdrücken. Die Lösemittelkonzentration im Gasraum sollte unterhalb der unteren Explosionsgrenze liegen. Vorteilhaft kann auch ein Trockengasstrom im Kreis geführt werden, wobei aus der Flexodruckplatte entwichenes Auswaschmittel in einer dazu geeigneten Vorrichtung abgetrennt wird und der abgereicherte Trockengasstrom wieder in die Trockeneinheit rückgeführt wird. Das Abtrennen des Lösemittels kann beispielsweise durch Kondensation bei tieferen Temperaturen oder Absorption an geeigneten Absorbern erfolgen.

Die Nachbehandlungseinheit (F) ist nicht in jedem Falle absolut erforderlich, sie ist daher nur optional. Sie ist aber zur oberflächlichen Entklebung der erhaltenen Flexodruckplatte im Regelfalle empfehlenswert. Die Nachbehandlungseinheit umfasst geeignete Strahlungsquellen zur Bestrahlung der Flexodruckplatte mit UV-A- und/oder UV-C-Licht.

Die Ausgabeeinheit (G) dient zum Ausgeben der fertigen Flexodruckplatte. Im einfachsten Fall kann es sich dabei um eine einfache Ausgabevorrichtung handeln, der die Flexodruckplatten manuell entnommen werden. Beispielsweise können die Flexodruckplatten auf einem Förderband aus der Nachbehandlungseinheit (F) herausgefahren werden. Die Ausgabeeinheit (G) kann aber auch ein Magazin umfassen, welches eine größere Menge von fertiggestellten Flexodruckelementen aufnehmen kann.

Die Transporteinheiten (H) verbinden die Einheiten (A) bis (G) miteinander und sorgen für den Transport der Flexodruckelemente - bzw. platten von einer Einheit zur nächsten. Die Transporteinheiten können gegebenenfalls auch mit den Transporteinheiten kombiniert sein, die für den Transport der Flexodruckelemente bzw. -platten innerhalb der Einheiten (B) bis (F) sorgen. Es ist denkbar, dass die Flexodruckelemente bzw. - platten auf einer einzigen Transportvorrichtung durch die gesamte erfindungsgemäße Vorrichtung hindurchgefahren werden. Bei der Transportvorrichtung kann es sich beispielsweise um ein Transportband handeln, auf das ein Flexodruckelement aufgelegt wird und mittels geeigneter Haltevorrichtungen, beispielsweise Stiften auf dem Band festgehalten und befördert wird.

In einer besonders vorteilhaften Ausführungsform der Erfindung umfasst die Transportvorrichtung magnetische Haltevorrichtungen. In Kombination damit wird ein Flexodruckelement eingesetzt, welches einen metallischen Träger aus einem magnetisierbaren Material umfasst. Beispielsweise kann ein Förderband eingesetzt werden, welches Magnete umfasst. Der metallische Träger wird von diesen Magneten auf dem Band festgehalten und somit durch die Vorrichtung gezogen. Es kann sich sowohl um Permanent- wie auch um Elektromagneten handeln.

Selbstverständlich sind auch andersartige Ausgestaltungen der Transporteinheiten denkbar. Die Flexodruckelemente bzw. -platten können beispielsweise durch Greifarme von einer Einheit zur nächsten weitergereicht werden.

Falls erforderlich, können die Transporteinrichtungen weiterhin Schleusen oder äquivalente Trennvorrichtungen aufweisen, die zur Abtrennung der einzelnen Einheiten voneinander dienen, und negative Effekte durch unerwünschte Einflüsse der einzelnen Einheiten aufeinander vermeiden sollen. Die Bauart hängt von den jeweils zu trennenden Einheiten ab. Eine trennende Einheit ist insbesondere zwischen der Waschvorrichtung und dem Trockner regelmäßig empfehlenswert.

Der Transport der Flexodruckelemente - bzw. platten mittels der Transporteinheiten erfolgt ebenfalls in ebenem Zustand der Platten.

Optional kann die erfindungsgemäße Vorrichtung noch weitere Funktionseinheiten umfassen. Falls das als Ausgangsmaterial eingesetzte fotopolymerisierbare Flexodruckelement eine Schutzfolie auf der digital bebilderbaren Schicht umfasst, kann die erfindungsgemäße Vorrichtung weiterhin eine Einheit (A') umfassen, mittels derer die Schutzfolie automatisch entfernt wird. Weiterhin kann eine Vorbelichtungseinheit (A") vorgesehen werden, mit der die gesamte fotopolymerisierbare Schicht noch vor der digitalen Bebilderung mittels UV-A-Licht vorbelichtet wird.

Die erfindungsgemäße Vorrichtung kann zur Herstellung von Flexodruckplatten ausgehend von üblichen digital bebilderbaren, fotopolymerisierbaren Flexodruckelementen, mindestens umfassend Träger, fotopolymerisierbare Schicht und digital bebilderbare Schicht, verwendet werden. Die Verwendung ist nicht auf bestimmte Typen von Flexodruckelementen beschränkt. So können beispielsweise auch dicke Flexodruckplatten mit einer Dicke von 2 bis 4 mm verarbeitet werden.

Die erfindungsgemäße Vorrichtung wird ganz besonders vorteilhaft für das erfindungsgemäße Verfahren zur Herstellung von Zeitungsflexoplatten eingesetzt.

Als Ausgangsmaterial für das erfindungsgemäße Verfahren wird bevorzugt ein fotopolymerisierbares Flexodruckelement eingesetzt, welches -übereinander angebrachtmindestens einen flexiblen metallischen Träger, eine fotopolymerisierbare Schicht sowie eine digital bebilderbare Schicht umfasst.

Als flexible metallische Träger kommen vor allem dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht, wobei die Metalle auch noch legiert sein können. Unter flexibel im Sinne dieser Erfindung soll verstanden werden, dass die Träger so dünn sind, dass sie um Druckzylinder gebogen werden können. Sie sind andererseits aber auch dimensionsstabil und so dick, dass der Träger bei der Produktion des Flexodruckelementes oder der Montage der fertigen Druckplatte auf den Druckzylinder nicht geknickt wird. Es können auch kombinierte metallische Träger wie beispielsweise mit Zinn, Zink, Chrom, Aluminium, Nickel oder auch Kombinationen verschiedener Metalle beschichtete Stahlbleche eingesetzt werden, oder auch solche Metallträger, die durch Laminieren gleich- oder verschiedenartiger Metallbleche erhalten werden. Weiterhin können auch vorbehandelte Bleche, wie beispielsweise phosphatierte oder chromatisierte Stahlbleche oder eloxierte Aluminiumbleche eingesetzt werden. Im Regelfalle werden die Bleche oder Folien vor dem Einsetzen entfettet. Bevorzugt eingesetzt werden Träger aus Stahl oder Aluminium, besonders bevorzugt ist magnetisierbarer Federstahl.

Die Dicke derartiger flexibler metallischer Träger beträgt üblicherweise zwischen 0,025 mm und 0,4 mm, und richtet sich neben dem gewünschten Grad an Flexibilität auch nach der Art des eingesetzten Metalls. Träger aus Stahl haben üblicherweise eine Dicke zwischen 0,025 und 0,25 mm, insbesondere zwischen 0,14 und 0,24 mm. Träger aus Aluminium haben üblicherweise eine Dicke zwischen 0,25 und 0,4 mm.

Es können aber selbstverständlich auch Flexodruckelemente eingesetzt werden, die einen Träger aus einem polymeren Material, beispielsweise PET, aufweisen.

Vorteilhaft weist der flexible metallische Träger eine sich darauf befindliche Haftschicht auf. Die Haftschicht vermittelt eine gute Haftung zwischen dem flexiblen, metallischen Träger und der später aufzubringenden fotopolymerisierbaren Schicht, so dass die durch bildmäßiges Belichten der fotopolymerisierbaren Schicht erhaltenen druckenden Elemente weder beim Entwickeln der Platte noch beim Drucken abreißen, abgelöst werden oder abknicken.

Im Prinzip können beliebige Haftschichten eingesetzt werden, vorausgesetzt, sie vermitteln ausreichende Haftung. Besonders vorteilhaft weist die Haftschicht einen UV-Absorber auf. Der UV-Absorber vermeidet, dass UV-Licht vom metallischen Träger zurück in die Reliefschicht gestreut wird. Derartige Reflektionen können u.U. den Belichtungsspielraum verringern und die mögliche Auflösung verschlechtern. Zur Ausführung der Erfindung besonders geeignete Haftschichten sind beispielsweise in DE-A 100 40 929 offenbart.

Das als Ausgangsmaterial eingesetzte Flexodruckelement umfasst weiterhin eine fotopolymerisierbare Schicht, welche ihrerseits mindestens ein elastomeres Bindemittel, ethylenisch ungesättigte Monomere, sowie einen Fotoinitiator oder ein Fotoinitiatorsystem umfasst. Optional könen noch weitere Bestandteile wie beispielsweise Weichmacher oder Hilfsstoffe vorhanden sein.

Bei der fotopolymerisierbaren Schicht kann es sich auch um mehrere fotopolymerisierbare Schichten übereinander handeln, die eine gleiche, annährend gleiche oder verschiedene Zusammensetzung aufweisen. Ein mehrschichtiger Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Bei den Bindemitteln kann es sich sowohl um elastomere wie um thermoplastisch elastomere Bindemittel handeln, welche üblicherweise zur Herstellung von Flexodruckelementen eingesetzt werden. Beispiele umfassen die bekannten Blockcopolymere vom Styrol-Isopren- oder Styrol-Butadien-Typ. Weitere Beispiele umfassen elastomere Polymere vom Ethylen/Propylen/Dien-Typ oder elastomere Polymere auf Basis von Acrylaten bzw. Acrylat-Copolymeren. Der Fachmann trifft unter den prinzipiell geeigneten Elastomeren je nach den gewünschten Eigenschaften der Schicht eine geeignete Auswahl. Die Menge an elastomerem Bindemittel in der Reliefschicht beträgt in der Regel 40 bis 90 Gew. % bzgl. der Menge aller Bestandteile. Bevorzugt werden 40 bis 85 % eingesetzt und besonders bevorzugt 40 bis 75 %.

Die fotoempfindliche Schicht enthält weiterhin in bekannter Weise polymerisierbare Verbindungen, beziehungsweise Monomere. Die Monomeren sollen mit den Bindemitteln verträglich sein und mindestens eine polymerisierbare, ethylenisch ungesättigte Doppelbindung aufweisen. Beispiele geeigneter Monomere umfassen (Meth)acrylate wie Butyl(meth)acrylat, 2-Ethylhexyl(meth)acrylat, Lauryl(meth)acrylat, 1,4-Butandioldi(meth)acrylat oder 1,6-Hexandioldi(meth)acrylat. Die Menge an Monomeren in der fotopolymerisierbaren Schicht beträgt in der Regel 4,9 bis 30 Gew. % bzgl. der Menge aller Bestandteile, bevorzugt 4,9 bis 20 Gew. %.

Die fotopolymerisierbare Schicht weist weiterhin in prinzipiell bekannter Art und Weise einen Fotoinitiator oder ein Fotoinitiatorsystem auf. Beispiele für geeignete Initiatoren sind Benzoin oder Benzoinderivate, wie Methylbenzoin oder Benzoinether. Die Menge an Fotoinitiator in der Reliefschicht beträgt in der Regel 0,1 bis 5 Gew. % bzgl. der Menge aller Bestandteile.

Die fotopolymere Schicht kann optional weitere Bestandteile, wie beispielsweise Inhibitoren für die thermisch initiierte Polymerisation, Weichmacher, Farbstoffe, Pigmente, fotochrome Zusätze, Antioxidantien, weitere Bindemittel zur Feinsteuerung der Eigenschaften oder Extrusionshilfsmittel umfassen. Im Regelfalle werden aber nicht mehr als 10 Gew. % derartiger Zusätze eingesetzt.

In einer bevorzugten Ausführungsform des erfindungsgemäßen Verfahrens wird als Ausgangsmaterial ein digital bebilderbares Flexodruckelement eingesetzt, bei dem als elastomeres Bindemittel in der fotopolymerisierbaren Schicht ein Styrol-Butadien-Blockcopolymeres mit einem Styrolgehalt von 20 bis 50 Gew. %, bevorzugt 25 bis 45 Gew. % und besonders bevorzugt 25 bis 35 Gew. % eingesetzt wird. Bevorzugt weist das SBS-Blockcopolymere eine Härte von 50 bis 80 Shore A gemäß ISO 868 auf. Besonders bevorzugt beträgt die Härte 55 bis 75 Shore A und ganz besonders bevorzugt 60 bis 75 Shore A. Es sollte weiterhin ein mittleres Molekulargewicht M_{w} (Gewichtsmittel) von 80 000 bis 150 000 g/mol aufweisen. Bevorzugt beträgt das Molekulargewicht 90 000 bis 140 000 g/mol und besonders bevorzugt 100 000 bis 130 000 g/mol. Geeignete SBS-Polymere sind beispielsweise unter dem Namen Kraton® erhältlich.

In der bevorzugten Ausführungsform wird das Bindemittel in Kombination mit einem geeigneten Weichmacher eingesetzt. Es können auch Gemische verschiedener Weichmacher eingesetzt werden. Beispiele geeigneter Weichmacher umfassen paraffinische Mineralöle; Ester von Dicarbonsäuren wie Dioctyladipat oder Terephthalsäuredioctylester, naphthenische Weichmacher oder Polybutadiene mit einem Molgewicht zwischen 500 und 5000 g/mol. Die Menge an Weichmacher in der fotopolymeren Schicht beträgt üblicherweise 5 bis 50 Gew. % bzgl. der Menge aller Bestandteile. Die genaue Menge wird vom Fachmann je nach dem verwendeten Bindemittel und der gewünschten Härte der Druckplatte gewählt. Bevorzugt werden 10 bis 40 % eingesetzt und besonders bevorzugt 20 bis 35 %.

Bei der digital bebilderbaren Schicht handelt es sich bevorzugt um eine Schicht ausgewählt aus der Gruppe der IR-ablativen Schichten, Ink-Jet-Schichten oder thermografischen Schichten.

IR-ablative Schichten bzw. Masken sind für die Wellenlänge des aktinischen Lichtes opak und umfassen üblicherweise mindestens ein Bindemittel und einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt. werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine mit Ink-Jet-Tinten beschreibbare Schicht, beispielsweise eine Gelatine-Schicht aufgetragen. Diese ist mittels Ink-Jet-Druckem bebilderbar. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf oder mittels IR-Lasem bebildert werden. Beispiele sind in EP-A 1 070 989 offenbart.

Die Herstellung des als Ausgangsmaterial eingesetzten Flexodruckelement kann beispielsweise erfolgen, indem man die Bestandteile der fotopolymerisierbaren Schicht, der digital bebilderbaren Schicht sowie optional der Haftschicht jeweils in einem geeigneten Lösungsmittel auflöst und schichtweise nacheinander auf den metallischen Träger aufträgt. Optional kann zum Schluss eine Schutzfolie, beispielsweise aus PET aufgebracht werden. Alternativ können die Schichten in umgekehrter Reihenfolge auf die Schutzfolie aufgegossen werden und zum Schluss wird der metallische Träger aufkaschiert. Ein geeignetes Verfahren ist beispielsweise in DE-A 100 40 929 offenbart.

Die bevorzugte Gesamtdicke des Flexodruckelementes aus metallischem Träger, Haftschicht, fotoempfindlicher Schicht und digital bebilderbarer Schicht -ohne eine optional vorhandene Schutzfolie- beträgt bevorzugt 400 bis 1000 *µ*m, besonders bevorzugt 400 bis 800 *µ*m und ganz besonders bevorzugt 450 bis 750 *µ*m.

Zur Durchführung des erfindungsgemäßen Verfahrens wird das Ausgangsmaterial in Schritt (a) zunächst in die Aufnahmeeinheit (A) eingelegt, beispielsweise durch Auflegen auf ein Förderband oder Bestücken des Magazins. Falls das Ausgangsmaterial eine Schutzfolie aufweist, muss diese für den Fall, dass die Aufnahmeeinheit keine automatische Abzugsvorrichtung aufweist, abgezogen werden.

In einer besonders vorteilhaften Ausgestaltung des erfindungsgemäßen Verfahrens wird das Flexodruckelement in einem Schritt (b) vorgelagerten Schritt vollflächig mit aktinischem Licht vorbelichtet. Die Lichtmenge wird dabei so limitiert, dass die fotopolymerisierbare Schicht auch nach dem Vorbelichten noch im Entwickler löslich ist; die Schicht darf also nicht in wesentlichem Umfange vemetzen. Hierfür ist im allgemeinen eine Belichtungszeit von wenigen Sekunden ausreichend. Dieser Schritt ist naturgemäß nur bei Flexodruckelemente mit transparenten Masken möglich, also beispielsweise bei Ink-Jet-Masken oder thermografischen Masken. Flexodruckelemente, die eine opake digital bebilderbare Schicht aufweisen können naturgemäß nicht vorbelichtet werden.

In Verfahrensschritt (b) wird die digital bebilderbare Schicht in der Bebilderungseinheit (B) mittels der jeweils erforderlichen Technik bebildert. Die Bildinformationen werden direkt einer Steuerungseinheit entnommen.

In Verfahrensschritt (c) wird das bebilderte Flexodruckelement mittels der Belichtungs-einheit (C) durch die erzeugte Maske hindurch mittels aktinischem, also chemisch wirksamem Licht bestrahlt. Bevorzugt ist hierbei UV-A- / VIS-Strahlung oder UV-A-Strahlung. Je nach der Art des Flexodruckelementes können aber auch andere Strahlungsquellen verwendet werden. Die fotopolymerisierbare Schicht polymerisiert hierbei in den transparenten Bereichen der Maske und bleibt in den von der Maske abgedeckten Bereichen unvemetzt.

In Verfahrensschritt (d) wird das bildmäßig bebilderte und belichtete Flexodruckelement mittels eines geeigneten Lösemittels oder einer Lösemittelkombination entwickelt. Hierbei werden die nicht belichteten, d.h. die von der Maske abgedeckten Bereiche der Reliefschicht entfemt, während die belichteten, d.h. die vernetzten Bereiche erhalten bleiben. Außerdem werden die Reste der digital bebilderbaren Schicht entfernt.

Das verwendete Lösungsmittel bzw. Lösungsmittelgemisch richtet sich nach der Art des ein gesetzten Flexodruckelementes. Falls das Flexodruckelement eine wässrig entwickelbare fotopolymerisierbare Schicht aufweist, können Wasser oder überwiegend wässrige Lösemittel eingesetzt werden. Für den Fall organisch entwickelbarer Flexodruckelemente eignen sich insbesondere die bekannten Auswaschmittel für Flexodruckplatten, die üblicherweise aus Gemischen verschiedener organischer Lösungsmittel bestehen, die auf geeignete Art und Weise zusammenwirken. Beispielsweise können Entwickler aus naphtenischen oder aromatischen Erdölfraktionen im Gemisch mit Alkoholen, beispielsweise Benzylalkohol oder Cyclohexanol, sowie ggf. weiteren Komponenten, wie beispielsweise alicyclischen Kohlenwasserstoffen, Terpen-Kohlenwasserstoffen, substituierten Benzolen, beispielsweise Düsopropylbenzol, oder Dipropylenglycoldimethylether eingesetzt werden. Geeignete Auswaschmittel sind beispielsweise in EP-A 332 070 oder EP-A 433 374 offenbart.

Der Entwicklungsschritt wird üblicherweise bei Temperaturen oberhalb 30°C durchgeführt. In einer bevorzugten Ausgestaltung der Erfindung wird der Entwicklungsschritt aufgrund der erzielbaren schnelleren Auswaschgeschwindigkeiten bei höheren Temperaturen durchgeführt. Aus Sicherheitsgründen und zur Reduktion des apparativen Aufwands beim Entwicklungsgerät sollte die Temperatur bei der Verwendung organische Lösemittel 5 bis 15°C unter dem Flammpunkt des eingesetzten Auswaschmittels liegen.

Die Trocknung der Flexodruckplatten in Verfahrensschritt (e) erfolgt vorzugsweise bei einer Temperatur von 105 bis 160°C, besonders bevorzugt bei 120 bis 150°C.

Falls die erfindungsgemäße Vorrichtung eine Nachbehandlungseinheit (F) aufweist, können die erhaltenen Flexodruckplatten in Verfahrensschritt (f) bei Bedarf noch einer entklebenden Nachbehandlung durch mit UV-A- und/oder UV-C-Licht unterzogen werden. Im Regelfalle ist ein solcher Schritt empfehlenswert. Wenn die Bestrahlung mit Licht unterschiedlicher Wellenlänge vorgesehen ist, kann sie gleichzeitig oder auch nacheinander erfolgen. Schließlich wird die fertige Flexodruckplatte über die Ausgabeeinheit (G) ausgegeben.

Zwischen den einzelnen Verfahrensschritten wird das Flexodruckelement bzw. die Flexodruckplatte jeweils mittels der Transporteinheit (H) von einer Einheit zur nächsten weiter transportiert. Das Flexodruckelement bzw, die Flexodruckplatte muss in keinem der Verfahrensschritte gebogen werden, sondern alle Schritte werden mit dem ebenen Flexodruckelement -bzw. der ebenen Platte durchlaufen.

Das erfindungsgemäße Verfahren erlaubt eine schnelle Verarbeitung von Flexodruckelementen zur fertigen Zeitungsflexoplatten. Bei den geschilderten Zeitungsflexoplatten können in der Regel Verarbeitungszeiten von deutlich unter 30 min erreicht werden.

## Patentansprüche

1. Vorrichtung zur in-line-Produktion von Flexodruckplatten mittels digitaler Bebilderung mindestens umfassend
(A) eine Einheit zur Aufnahme digital bebilderbarer, fotopolymerisierbarer Flexodruckelemente mit einer Dicke von 0,4 bis 1 mm,
(B) eine Einheit zur digitalen Bebilderung des Flexodruckelementes, die mindestens zwei gleichartige Funktionseinheiten, ausgewählt aus der Gruppe von IR-Lasern, Ink-Jet-Druckköpfen oder Thermodruckköpfen, umfasst,
(C) eine Belichtungseinheit,
(D) eine Auswascheinheit,
(E) eine Trocknungseinheit,
(F) optional eine Nachbehandlungseinheit,
(G) eine Ausgabeeinheit für die erhaltenen Flexodruckplatten, sowie
(H) Transporteinheiten für die Flexodruckelemente - bzw. formen, die die Einheiten (A) bis (G) miteinander verbinden,
wobei die Einheiten (A) bis (H) so ausgelegt sind, dass die Flexodruckelemente bzw. -platten in ebenem Zustande verarbeitet werden.

2. Vorrichtung gemäß Anspruch 1, **dadurch gekennzeichnet, dass** die Transporteinheiten magnetische Haltevorrichtungen umfassen.

3. Vorrichtung gemäß Anspruch 1 oder 2, **dadurch gekennzeichnet, dass** die Vorrichtung weiterhin eine Einheit zur Vorbelichtung der fotoempfindlichen Flexodruckelemente umfasst.

4. Verwendung der Vorrichtung gemäß einem der Ansprüche 1 bis 3 zur Herstellung von Flexodruckplatten.

5. Verfahren zur Herstellung von Flexodruckplatten für den Zeitungsdruck, bei dem man als Ausgangsmaterial ein fotoempfindliches Flexodruckelement mit einer Dicke von 0,4 bis 1 mm, umfassend -übereinander angeordnet - mindestens
• einen flexiblen, metallischen Träger,
• eine fotopolymerisierbare Schicht, welche ihrerseits mindestens ein elastomeres Bindemittel, ethylenisch ungesättigte Monomere und einen Fotoinitiator umfasst, sowie
• eine digital bebilderbare Schicht, ausgewählt aus der Gruppe der IR-ablativen Schichten, Ink-Jet-Schichten oder thermografischen Schichten
- einsetzt, **dadurch gekennzeichnet, dass** man eine Vorrichtung gemäß einem der Ansprüche 1 bis 6 einsetzt und das Verfahren die folgenden Schritte umfasst:
(a) Einlegen der fotoempfindlichen Flexodruckelemente in die Aufnahmeeinheit (A),
(b) bildmäßiges Beschreiben der digital bebilderbaren Schicht mittels der Bebilderungseinheit (B) zur Erzeugung einer Maske auf dem Flexodruckelement,
(c) Belichten des Flexodruckelementes mit aktinischem Licht mittels der Belichtungseinheit (C) durch die erzeugte Maske hindurch ,
(d) Entfernen nicht belichteter Bereiche des Flexodruckelements sowie der Reste der digital bebilderbaren Schicht mittels eines geeigneten Lösemittels oder einer geeigneten Lösemittelkombination in der Auswascheinheit (D),
(e) Trocknen der ausgewaschenen Flexodruckform bei einer Temperatur von 105 bis 160°C in der Trocknungseinheit (E),
(f) Optional Nachbehandeln der getrockneten Flexodruckform mittel UVA- und/oder UVC-Licht,
(g) Ausgeben der fertigen Flexodruckplatte,
wobei das Flexodruckelement bzw. die -platte durch die Transporteinrichtung (H) von einer Einheit zu der jeweils nächsten befördert wird und während des gesamten Verarbeitungsvorganges nicht gebogen wird.

6. Verfahren gemäß Anspruch 5, **dadurch gekennzeichnet, dass** das Flexodruckelement weiterhin in einem (b) vorangehenden Schritt mit aktinischem Licht vorbelichtet wird, mit der Maßgabe, dass ein Flexodruckelement eingesetzt wird, dessen digital bebilderbare Schicht eine ausreichende Transparenz für aktinisches Licht aufweist.

7. Verfahren gemäß Anspruch 5 oder 6, **dadurch gekennzeichnet, dass** es sich bei dem metallischen Träger um magnetisierbaren Federstahl handelt.

8. Verfahren gemäß einem der Ansprüche 5 bis 7, **dadurch gekennzeichnet, dass** es sich bei dem Bindemittel in der fotopolymerisierbaren Schicht um mindestens ein Styrol-Butadien-Blockcopolymeres mit einem Styrol-Gehalt von 20 bis 50 Gew. % handelt.

9. Verfahren gemäß Anspruch 8, **dadurch gekennzeichnet, dass** das Blockcopolymere ein mittleres Molekulargewicht M_{w} von 80 000 bis 150 000 g/mol aufweist.

10. Verfahren gemäß Anspruch 8 oder 9, **dadurch gekennzeichnet, dass** das Styrol-Butadien-Blockcopolymere eine Härte von 55 bis 75 Shore A aufweist.

11. Verfahren gemäß einem der Ansprüche 8 bis 10, **dadurch gekennzeichnet, dass** die fotopolymerisierbare Schicht weiterhin 5 bis 50 Gew. % eines Weichmachers umfasst.

## Claims

1. An apparatus for the in-line production of flexographic printing plates by means of digital imaging, at least comprising
(A) a unit for holding digitally imageable, photopolymerizable, flexographic printing elements having a thickness of from 0.4 to 1 mm,
(B) a unit for the digital imaging of the flexographic printing element, which comprises at least two functional units of the same type, selected from the group consisting of 1 R lasers, inkjet printing heads or thermal printing heads,
(C) an exposure unit,
(D) a washout unit,
(E) a drying unit,
(F) optionally an aftertreatment unit,
(G) an output unit for the flexographic printing plates obtained, and
(H) transport units for the flexographic printing elements or plates, which connect the units (A) to (G) to one another,
the units (A) to (H) being designed so that the flexographic printing elements or plates are processed in the flat state.

2. The apparatus according to claim 1, wherein the transport units comprise magnetic retaining apparatuses.

3. The apparatus according to claim 1 or 2, which furthermore comprises a unit for preexposure of the photosensitive flexographic printing elements.

4. The use of the apparatus according to any of claims 1 to 3 for the production of flexographic printing plates.

5. A process for the production of flexographic printing plates for newspaper printing, in which the starting material used is a photosensitive flexographic printing element having a thickness of from 0.4 to 1 mm, comprising - arranged one on top of the other - at least
• a flexible, metallic substrate,
• a photopolymerizable layer which in turn comprises at least one elastomeric binder, ethylenically unsaturated monomers and a photoinitiator, and
• a digitally imageable layer, selected from the group consisting of 1 R-ablative layers inkjet layers or thermographic layers
wherein an apparatus as claimed in any of claims 1 to 6 is used and the process comprises the following steps:
(a) placing of the photosensitive flexographic elements in the holding unit (A),
(b) imagewise recording on the digitally imageable layer by means of the imaging unit (B) for producing a mask on the flexographic printing element,
(c) exposure of the flexographic printing element to actinic light by means of the exposure unit (C) through the mask produced,
(d) removal of unexposed parts of the flexographic printing element and the residues of the digitally imageable layer by means of a suitable solvent or of a suitable solvent combination in the washout unit (D),
(e) drying of the washed out flexographic printing plate at from 105 to 160°C in the drying unit (E),
(f) optionally aftertreatment of the dried flexographic printing plate by means of UVA and/or UVC light and
(g) output of the finished flexographic printing plate,
the flexographic printing element or the flexographic printing plate being transported by the transport means (H) from one unit to the respective next unit and not being bent during the entire processing procedure.

6. The process according to claim 5, wherein the flexographic printing element is furthermore preexposed to actinic light in a step preceding (b), with the proviso that a flexographic printing element whose digitally imageable layer has a sufficient transparency to actinic light is used.

7. The process according to claim 5 or 6, wherein the metallic substrate comprises magnetizable spring steel.

8. The process according to any of claims 5 to 7, wherein the binder in the photopolymerizable layer is at least one styrene/butadiene block copolymer having a styrene content of from 20 to 50% by weight.

9. The process according to claim 8 wherein the block copolymer has an average molecular weight M_{w} of from 80 000 to 150 000 g/mol.

10. The process according to claim 8 or 9, wherein the styrene/butadiene block copolymer has a Shore A hardness of from 55 to 75.

11. The process according to any of claims 8 to 10, wherein the photopolymerizable layer furthermore comprises from 5 to 50% by weight of a plasticizer.

## Revendications

1. Dispositif de production "in line" de plaques flexographiques au moyen d'imagerie numérique, comprenant au moins
(A) une unité de réception d'éléments flexographiques photopolymérisables pouvant être imagés numériquement d'une épaisseur de 0,4 à 1 mm,
(B) une unité pour l'imagerie numérique de l'élément flexographique, comprenant au moins deux unités fonctionnelles similaires, choisies dans le groupe des lasers IR, des têtes d'impression à jet d'encre ou des têtes d'impression thermiques,
(C) une unité d'exposition,
(D) une unité de lavage,
(E) une unité de séchage,
(F) en option, une unité de traitement ultérieur,
(G) une unité de sortie pour les plaques flexographiques obtenues, ainsi que
(H) des unités de transport pour les éléments flexographiques ou moules d'impression flexographiques, qui relient entre elles les unités (A) à (G), les unités (A) à (H) étant conçues de façon telle, que les éléments flexographiques ou plaques flexographiques sont traités en position plane.

2. Dispositif selon la revendication 1, **caractérisé en ce que** les unités de transport comprennent des dispositifs de maintien magnétiques.

3. Dispositif selon la revendication 1 ou 2, **caractérisé en ce que** le dispositif comprend par ailleurs une unité pour la prélumination des éléments flexographiques photosensibles.

4. Utilisation du dispositif selon l'une quelconque des revendications 1 à 3 pour la fabrication de plaques flexographiques.

5. Procédé de fabrication de plaques flexographiques pour l'impression de journaux, dans lequel on utilise en tant que produit de départ un élément flexographique photosensible d'une épaisseur de 0,4 à 1 mm, comprenant (de façon superposée)
- un support métallique flexible
- une couche photopolymérisable, qui pour sa part comprend au moins un liant élastomère, des monomères éthylèniquement insaturés et un photoinitiateur, ainsi que
- une couche pouvant être numériquement imagée, choisie dans le groupe des couches IR-ablatives des couches à jet d'encre ou des couches thermographiques,
**caractérisé en ce qu'**on utilise un dispositif selon l'une quelconque des revendications 1 à 6 et **en ce que** le procédé comprend les étapes suivantes
(a) insertion des éléments flexographiques photosensibles dans l'unité de réception (A),
(b) transfert d'image de la couche pouvant être numériquement imagée au moyen de l'unité d'imagination (B) pour la création d'un masque sur l'élément flexographique,
(c) exposition de l'élément flexographique à une lumière actinique au moyen de l'unité d'exposition (C), à travers le masque créé,
(d) retrait des zones non exposées de l'élément flexographique, ainsi que des restes de la couche pouvant être numériquement imagée au moyen d'un solvant adapté ou d'une association adaptée de solvants dans l'unité de lavage (D),
(e) séchage du moule d'impression flexographique lavé à une température de 105 à 160°C dans l'unité de séchage (E),
(f) traitement ultérieur optionnel du moule d'impression flexographique séché au moyen d'une lumière UVA et/ou UVC,
(g) sortie de la plaque flexographique finie,
l'élément flexographique ou plaque flexographique étant convoyé par le dispositif de transport (H) d'une unité vers l'unité respectivement suivante et n'étant pas courbé pendant l'ensemble du processus de traitement.

6. Procédé selon la revendication 5, **caractérisé en ce que** par ailleurs, on pré-expose l'élément flexographique à une lumière actinique au cours d'une étape préalable à (b), sous réserve d'utiliser un élément flexographique dont la couche pouvant être numériquement imagée fait preuve d'une transparence suffisante à la lumière actinique.

7. Procédé selon la revendication 5 ou 6, **caractérisé en ce que** le support métallique est de l'acier à ressorts magnétisable.

8. Procédé selon l'une quelconque des revendications 5 à 7, **caractérisé en ce que** le liant dans la couche photopolymérisable est au moins un copolymère bloc de styrène-butadiène, avec une teneur en styrène de 20 à 50 % en poids.

9. Procédé selon la revendication 8, **caractérisé en ce que** le copolymère bloc présente un poids moléculaire moyen M_{w} de 80 000 à 150 000 g/mole.

10. Procédé selon la revendication 8 ou 9, **caractérisé en ce que** le copolymère bloc styrène-butadiène présente une dureté de 55 à 75 shore A.

11. Procédé selon l'une quelconque des revendications 8 à 10, **caractérisé en ce que** la couche photopolymérisable comprend par ailleurs de 5 à 50 % en poids d'un plastifiant.
